# EUROPEAN PATENT APPLICATION

(11) **EP 2 770 639 A1**
(43) Date of publication of application: **27.08.2014**
(21) Application number: 13169426.7
(22) Date of filing: 28.05.2013
(51) Int. Cl.: H03K 17/96, F24C 7/08

(54) **Switch control module with strain gage and electric device employing same**

(30) Priority: 20.02.2013 TW 102105806
(71) Applicant: Delta Electronics, Inc., Taoyuan Hsien 333 (TW)
(72) Inventor: Lin, I-Shen, 320 Chungli Industrial Zone, Taoyuan Hsien (TW)
(74) Representative: 2K Patentanwälte Blasberg Kewitz & Reichel

(57) **Abstract**

A switch control module (2) for an electric device (4) is provided. The switch control module (2) includes a substrate (21) and at least one strain gage (22). The substrate (21) includes a first surface (211) and a second surface (212), wherein at least one operating area (213) is formed on the first surface (211). The at least one strain gage (22) is attached on the second surface (212) of the substrate (21) and aligned with the at least one operating area (213). In response to an external force exerted on the at least one operating area (213) of the substrate (21), the at least one strain gage (22) is subjected to deformation. According to an amount of the deformation, a control signal is generated to control operations of the electric device (4).

## Description

### FIELD OF THE INVENTION

The present invention relates to a switch control module, and more particularly to a switch control module with a strain gage. The present invention also relates to an electric device with the switch control module.

### BACKGROUND OF THE INVENTION

With increasing development and advance of electronic industries, a variety of information home appliances such as electric cookers, induction cookers or microwave ovens are widely used to cook food. Moreover, these information home appliances gradually become essential electric devices in our daily lives.

For example, an induction cooker is used to cook food according to electromagnetic induction. When a current flows through an induction coil of the induction cooker, a conductor such as a foodstuff container (e.g. an iron pot, a stainless steel pot or a metal pot) is placed in a magnetic field which varies with time. Consequently, the magnetic flux passing through the conductor will change with time, and an eddy current will be produced to resist the change of the magnetic flux. When the eddy current flows through a resistor, heat is generated. Since the eddy current can quickly heat the conductor (i.e. the foodstuff container), the food within the foodstuff container can be effectively cooked.

A process of fabricating an induction cooker will be illustrated as follows. Firstly, a winding coil, an insulating plate and a magnetic core assembly are positioned on a positioning plate, thereby collaboratively defining a magnetic element. Then, the magnetic element is placed on a supporting plate within the induction cooker, and the magnetic element is electrically connected with a circuit board. After the induction cooker is fabricated, the magnetic element may produce an eddy current to heat the foodstuff container which is placed on the electric device.

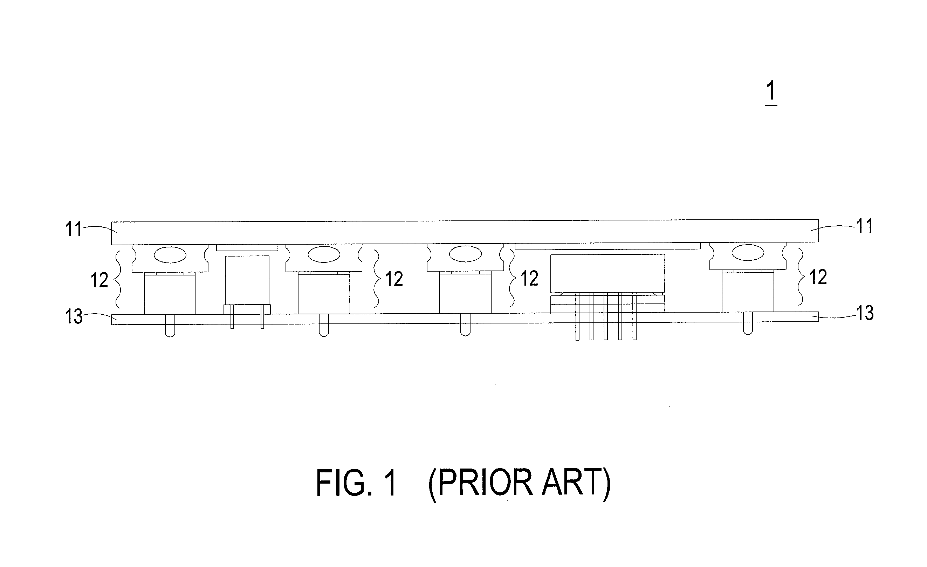

Moreover, the induction cooker has a switch control module. The switch control module is disposed on a casing of the induction cooker. FIG. 1 is a schematic side view illustrating a conventional switch control module. As shown in FIG. 1, the switch control module 1 comprises a ceramic glass plate 11 and plural capacitive induction switches 12. The plural capacitive induction switches 12 are electrically connected with a circuit board 13 for controlling on/off states of corresponding magnetic elements (not shown). The capacitive induction switch 12 is a capacitor-based switch. When a conductor (e.g. a finger) touches a key on the surface of the ceramic glass plate 11, the movement of the charges from the user's finger results in the change of the capacitance value of the corresponding capacitive induction switch 12. When the change of the capacitance value is detected by a detecting circuit of a built-in controller (not shown), a corresponding action is controlled by the controller according to the detecting result.

Although the conventional switch control module 1 is capable of controlling the operations of the induction cooker, there are still some drawbacks. For example, if the soup splashes or overflows on the surface of the ceramic glass plate 11 to result in the environment change, the key on the surface of the ceramic glass plate 11 may be erroneously touched. Consequently, the capacitance value of the capacitive induction switch 12 changes. Under this circumstance, the capacitive induction switch 12 is suffered from an erroneous action to activate an unexpected function. Meanwhile, the use of the induction cooker is at risk.

Therefore, there is a need of providing a switch control module with a strain gage and an electric device with the switch control module in order to eliminate the above drawbacks.

### SUMMARY OF THE INVENTION

The present invention provides a switch control module with a strain gage and an electric device with the switch control module in order to avoid the generation of the erroneous action and increase the safety of operating the electric device.

In accordance with an aspect of the present invention, there is provided a switch control module for an electric device. The switch control module includes a substrate and at least one strain gage. The substrate includes a first surface and a second surface, wherein at least one operating area is formed on the first surface. The at least one strain gage is attached on the second surface of the substrate and aligned with the at least one operating area. In response to an external force exerted on the at least one operating area of the substrate, the at least one strain gage is subjected to deformation. According to an amount of the deformation, a control signal is generated to control operations of the electric device.

In accordance with another aspect of the present invention, there is provided an electric device. The electric device includes a covering member, a casing, a magnetic element, a circuit board, and a switch control module. The magnetic element is disposed within the casing. The circuit board is disposed within the casing and electrically connected with the magnetic element. The switch control module is electrically connected with the circuit board, and located at an edge of the covering member. The switch control module includes a substrate and at least one strain gage. The substrate includes a first surface and a second surface, wherein at least one operating area is formed on the first surface. The at least one strain gage is attached on the second surface of the substrate and aligned with the at least one operating area. In response to an external force exerted on the at least one operating area of the substrate, the at least one strain gage is subjected to deformation. According to an amount of the deformation, a control signal is generated to control operations of the electric device.

The above contents of the present invention will become more readily apparent to those ordinarily skilled in the art after reviewing the following detailed description and accompanying drawings, in which:

### BRIEF DESCRIPTION OF THE DRAWINGS

FIG. 1 is a schematic side view illustrating a conventional switch control module;

FIG. 2A is a schematic perspective view illustrating a switch control module according to a first embodiment of the present invention;

FIG. 2B is a schematic cross-sectional view illustrating the connection between the switch control module of FIG. 2A and a first circuit board of an electric device;

FIG. 2C is a schematic view illustrating a strain gage of the switch control module of FIG. 2B;

FIG. 3 is a schematic cross-sectional view illustrating the connection between an electric device and a switch control module according to a second embodiment of the present invention; and

FIG. 4 is a schematic perspective view illustrating the outward appearance of an electric device with the switch control module of the present invention.

### DETAILED DESCRIPTION OF THE PREFERRED EMBODIMENT

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

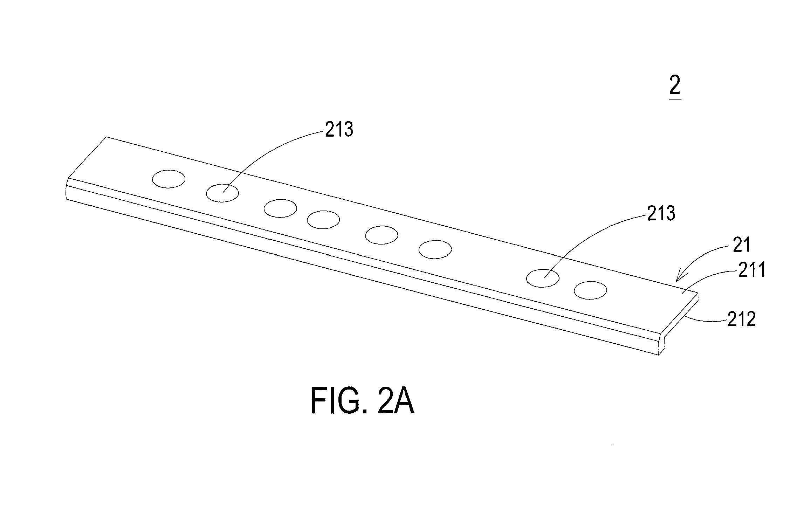

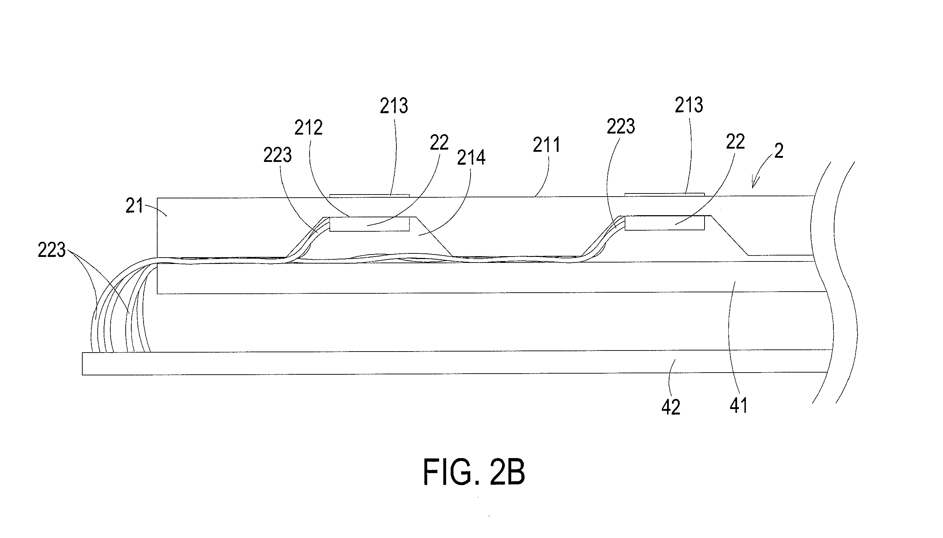

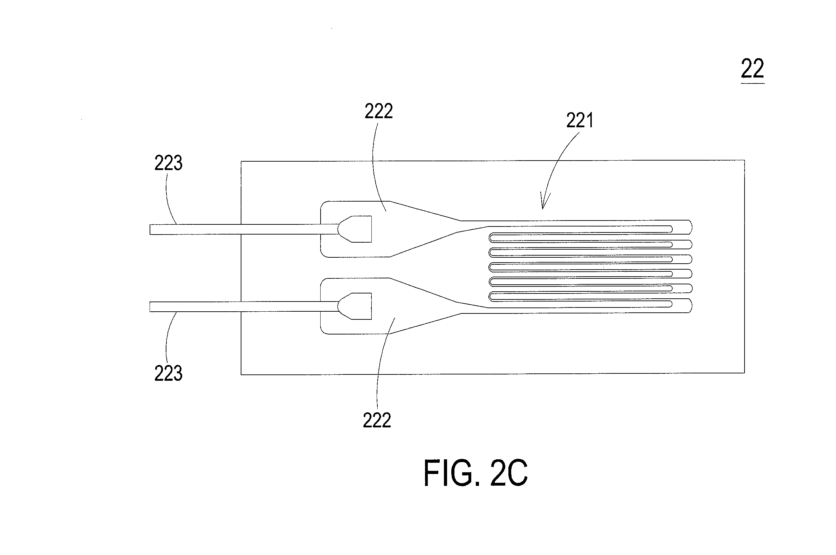

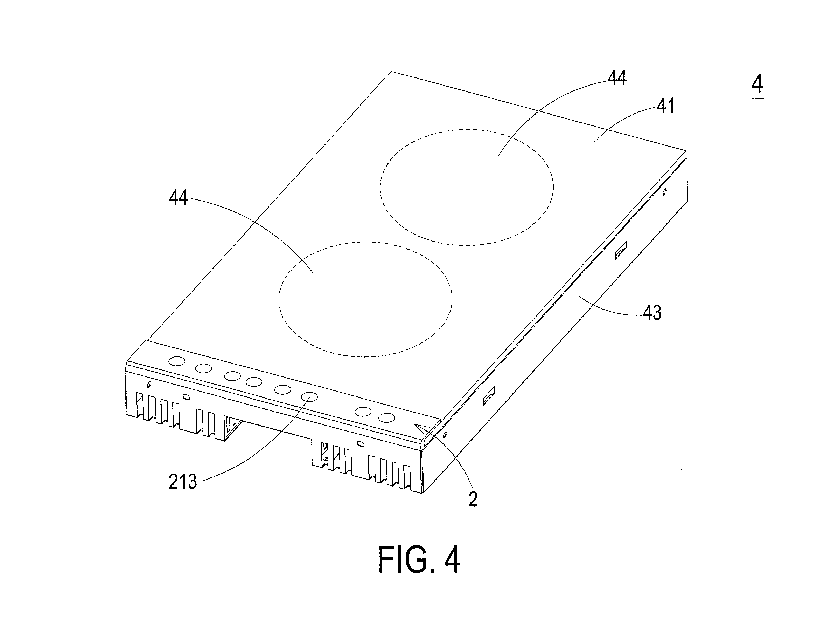

FIG. 2A is a schematic perspective view illustrating a switch control module according to a first embodiment of the present invention. FIG. 2B is a schematic cross-sectional view illustrating the connection between the switch control module of FIG. 2A and a first circuit board of an electric device. FIG. 2C is a schematic view illustrating a strain gage of the switch control module of FIG. 2B. FIG. 4 is a schematic perspective view illustrating the outward appearance of an electric device with the switch control module of the present invention. Please refer to FIGS. 2A, 2B, 2C and 4. The switch control module 2 is applied to an electric device 4. For example, the electric device 4 is an induction cooker. As shown in FIGS. 2B and 4, the switch control module 2 is located at an edge of a covering member 41 of the electric device 4. The switch control module 2 mainly comprises a substrate 21 and at least one strain gage 22. Moreover, the electric device 4 further comprises a first circuit board 42, which is electrically connected with the at least one strain gage 22.

Please refer to FIGS. 2A and 2B. The substrate 21 is located at the edge of a covering member 41 of the electric device 4. Moreover, the substrate 21 comprises a first surface 211, a second surface 212, and a concave structure 214. The first surface 211 is an outer surface of the substrate 21. The second surface 212 is an inner surface of the substrate 21. Moreover, at least one operating area 213 is formed on the first surface 211. In this embodiment, the switch control module 2 comprises plural operating areas 213. Moreover, these operating areas 213 are printed on the first surface 211 of the switch control module 2 for receiving external forces which are exerted thereon. The second surface 212 of the substrate 21 is disposed within the concave structure 214 and opposed to the first surface 211. An example of the substrate 21 includes but is not limited to a metal substrate. The type of the substrate 21 is not restricted as long as the substrate 21 is subjected to deformation in response to an external force. For example, the substrate 21 may be a bamboo substrate.

Please refer to FIG. 2C again. An example of the strain gage 22 includes but is not limited to a resistive strain gage. The strain gage 22 is used for transforming the mechanical strain into an electronic signal. By measuring the strain in response to an external force, the operations of the electric device 4 are controlled according to the strain. Moreover, the strain gage 22 comprises a main body 221 and plural output terminals 222. The main body 221 is composed of a conductive wire. The output terminals 222 are connected with corresponding transmission wires 223. If the conductive wire of the main body 221 is expanded or contracted in response to the external force, the length of the conductive wire and the cross-section area of the main body 221 are subjected to change. Consequently, the resistance value of the conductive wire changes.

Please refer to FIG. 2B again. In this embodiment, the switch control module 2 comprises plural strain gages 22. The strain gages 22 are disposed within respective concave structures 214 of the substrate 21 and attached on the second surface 212 of the substrate 21. In addition, the plural strain gages 22 are aligned with respective operating areas 213. In response to an external force exerted on one of the operating areas 213 of the substrate 21 (e.g. by the user's finger), the corresponding strain gage 22 is subjected to deformation. According to the amount of the deformation, a control signal is generated to control operations of the electric device 4. That is, according to the resistance change of the conductive wire of the main body 221, the strain gage 22 generates the control signal. The control signal is transmitted to a detecting circuit of a controller (not shown) of the first circuit board 42. According to the detecting result, the operations of the electric device 4 are controlled by the controller. In an embodiment, the strain gage 22 generates the control signal in response to an external force between 2N and 4N. It is noted that the range of the external force for generating the control signal may be adjusted according to the practical requirements.

Please refer to FIGS. 2B and 2C again. In this embodiment, the output terminals 222 of each strain gage 22 are connected with the first circuit board 42 of the electric device 4 through the transmission wires 223. Consequently, the control signal can be transmitted from the strain gage 22 to the first circuit board 42.

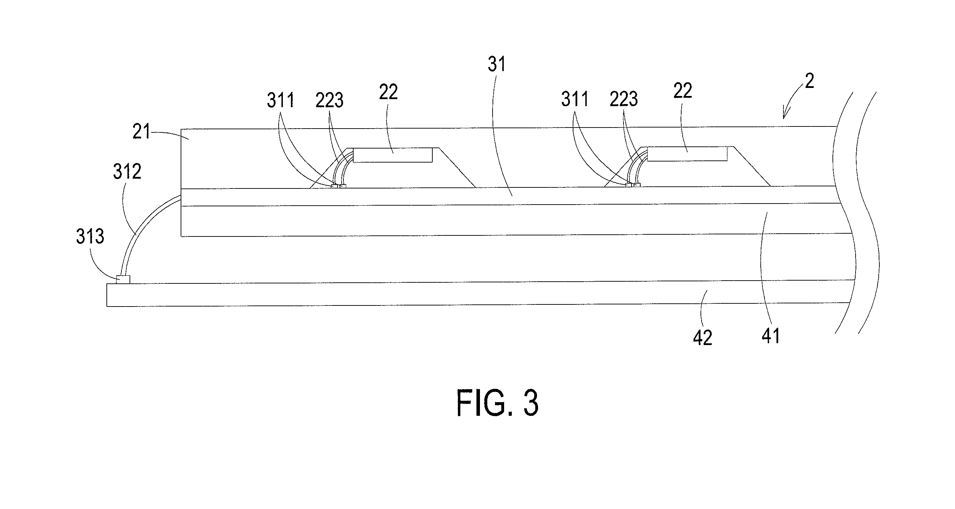

It is noted that the connection between the strain gage 22 and the first circuit board 42 may be varied. FIG. 3 is a schematic cross-sectional view illustrating the connection between an electric device and a switch control module according to a second embodiment of the present invention. In this embodiment, the switch control module 2 further comprises a second circuit board 31. The second circuit board 31 is arranged between the substrate 21 and the covering member 41. The second circuit board 31 comprises plural contacts 311, a transmission wire 312, and a connector 313. The contacts 311 are connected with corresponding transmission wires 223 of each strain gage 22. The transmission wire 312 of the second circuit board 31 is connected with the connector 313. The connector 313 is disposed on the first circuit board 42. Consequently, the control signal generated by each strain gage 22 is transmitted to the first circuit board 42 through the plural contacts 311, the transmission wire 312 and the connector 313 of the second circuit board 31.

From the above discussions, the switch control module 2 is capable of controlling operations of the electric device 4 according to the deformation amount of the strain gage 22 in response to an external force exerted on an operating area 213 of the substrate 21. Moreover, the control signal is generated when the deformation amount is higher than a threshold value, thereby controlling the operations of the electric device 4. If the soup splashes or overflows on the surface of the operating area to result in the environment change, the strain gage 22 is not suffered from erroneous action. Consequently, it is impossible to activate the unexpected function. Under this circumstance, the safety of using the electric device 4 is enhanced, and thus the drawbacks encountered from the conventional switch control module will be eliminated.

Please refer to FIG. 4 again. In addition to the covering member 41 and the first circuit board 42, the electric device 4 further comprises a casing 43, a magnetic element 44 and the switch control module 2. The first circuit board 42 is disposed within the casing 43, and connected with the magnetic element 44 and the switch control module 2. The covering member 41 is disposed over the magnetic element 44, and connected with the casing 43. The covering member 41 is made of an insulating and heat-barrier hard material, but is not limited thereto. The magnetic element 44 is aligned with a heating area of the covering member 41, wherein a foodstuff container (not shown) is placed on the heating area to be heated.

The magnetic element 44 is disposed within the casing 43. Moreover, the magnetic element 44 comprises a winding coil, an insulating plate and a magnetic core assembly, which are not shown in the drawings. Under control of the controller of the first circuit board 42, the magnetic element 44 generates electromagnetic induction. Due to the electromagnetic induction, an eddy current is produced to heat the foodstuff container (not shown) on the heating area of the electric device 4.

The switch control module 2 is connected with the first circuit board 42, and located at an edge of the covering member 41. The components, operating principles and the objects of the switch control module 2 have been mentioned in the first embodiments, and are not redundantly described herein.

From the above descriptions, the present invention provides a switch control module with a strain gage and an electric device with the switch control module. The switch control module is capable of controlling operations of the electric device according to the deformation amount of the strain gage in response to an external force exerted on an operating area of the substrate. If the soup splashes or overflows on the surface of the operating area to result in the environment change, the strain gage is not suffered from erroneous action. Consequently, it is impossible to activate the unexpected function. Under this circumstance, the safety of using the electric device is enhanced, and thus the drawbacks encountered from the conventional switch control module will be eliminated. Therefore, the switch control module and the electric device of the present invention possess industrial values.

## Claims

1. A switch control module (2) for an electric device (4), said switch control module (2) comprising:
a substrate (21) comprising a first surface (211) and a second surface (212), wherein at least one operating area (213) is formed on said first surface (211); and
at least one strain gage (22) attached on said second surface (212) of said substrate (21) and aligned with said at least one operating area (213), wherein in response to an external force exerted on said at least one operating area (213) of said substrate (21), said at least one strain gage (22) is subjected to deformation, wherein according to an amount of said deformation, a control signal is generated to control operations of said electric device (4).

2. The switch control module according to claim 1, wherein said at least one strain gage (22) comprises plural output terminals (222) for outputting said control signal.

3. The switch control module according to claim 2, wherein said electric device (4) comprises a first circuit board (42).

4. The switch control module according to claim 3, wherein said plural output terminals (222) of said at least one strain gage (22) are connected with said first circuit board (42) through transmission wires (223), so that said control signal is transmitted from said at least one strain gage (22) to said first circuit board (42).

5. The switch control module according to claim 3 or 4, wherein said switch control module (2) further comprises a second circuit board (31), wherein said second circuit board (31) is connected with said plural output terminals (222) of said at least one strain gage (22) and said first circuit board (42), so that said control signal is transmitted from said at least one strain gage (22) to said first circuit board (42).

6. The switch control module according to any of the claims 1 to 5, wherein said electric device (4) is an induction cooker.

7. The switch control module according to any of the claims 1 to 6, wherein said substrate (21) is a metal substrate.

8. The switch control module according to any of the claims 1 to 7, wherein said strain gage (22) is a resistive strain gage.

9. The switch control module according to any of the claims 1 to 8, wherein said operating area (213) is printed on said first surface (211) of said substrate (21).

10. An electric device (4), comprising:
a covering member (41);
a casing (43);
a magnetic element (44) disposed within said casing (43);
a circuit board (42) disposed within said casing (43) and electrically connected with said magnetic element (44); and
a switch control module (2) electrically connected with said circuit board (42), and located at an edge of said covering member (41), wherein said switch control module (2) comprises:
a substrate (21) comprising a first surface (211) and a second surface (212), wherein at least one operating area (213) is formed on said first surface (211); and
at least one strain gage (22) attached on said second surface (212) of said substrate (21) and aligned with said at least one operating area (213), wherein in response to an external force exerted on said at least one operating area (213) of said substrate (21), said at least one strain gage (22) is subjected to deformation, wherein according to an amount of said deformation, a control signal is generated to control operations of said electric device (4).
